# EUROPÄISCHE PATENTSCHRIFT

(11) **EP 1 444 709 B1**
(45) Veröffentlichungstag und Bekanntmachung des Hinweises auf die Patenterteilung: **12.08.2009**
(21) Anmeldenummer: 02782702.1
(22) Anmeldetag: 08.10.2002
(51) Int. Cl.: H01F 41/30, H01F 10/32, G11C 11/16

(54) **VERFAHREN ZUR HOMOGENEN MAGNETISIERUNG EINES AUSTAUSCHGEKOPPELTEN SCHICHTSYSTEMS EINER DIGITALEN MAGNETISCHEN SPEICHERZELLENEINRICHTUNG**
METHOD FOR HOMOGENEOUSLY MAGNETIZING AN EXCHANGE-COUPLED LAYER SYSTEM OF A DIGITAL MAGNETIC MEMORY LOCATION DEVICE
PROCEDE D'AIMANTATION HOMOGENE D'UN SYSTEME DE COUCHES COUPLEES PAR ECHANGE D'UN DISPOSITIF DE CELLULES DE MEMOIRE MAGNETIQUE NUMERIQUE

(30) Priorität: 12.11.2001 DE 10155424
(43) Veröffentlichungstag der Anmeldung: 11.08.2004
(73) Patentinhaber: Infineon Technologies AG, 81669 München (DE)
(72) Erfinder: BRÜCKL, Hubert, 33615 Bielefeld (DE); KLOSTERMANN, Ulrich, 94227 Zwiesel (DE); WECKER, Joachim, 91341 Röttenbach (DE)
(74) Vertreter: Kottmann, Heinz Dieter
(86) Internationale Anmeldenummer: PCT/DE2002/003789
(87) Internationale Veröffentlichungsnummer: WO 2003/043036

(56) Entgegenhaltungen:
- TONG H C ET AL: "THE SPIN FLOP OF SYNTHETIC ANTIFERROMAGNETIC FILMS" JOURNAL OF APPLIED PHYSICS, AMERICAN INSTITUTE OF PHYSICS. NEW YORK, US, Bd. 87, Nr. 9, 1. Mai 2000 (2000-05-01), Seiten 5055-5057, XP000947735 ISSN: 0021-8979

## Beschreibung

Die Erfindung betrifft ein Verfahren zur homogenen Magnetisierung eines austauschgekoppelten Schichtsystems einer digitalen magnetischen Speicherzelleneinrichtung umfassend ein magnetische Schichten aufweisendes AAF-Schichtsystem und eine eine Schicht des AAF-Schichtsystems austauschkoppelnde antiferromagnetische Schicht.

Eine derartige digitale Speicherzelleneinrichtung dient zum Speichern von Informationen auf magnetischer Basis. Eine einzelne Speicherzelleneinrichtung ist in der Regel Teil einer Speichereinrichtung, häufig auch MRAM (Magnetic Random Access Memory) genannt. Mit einem derartigen Speicher können. Lese- und/oder Schreiboperationen durchgeführt werden. Jede einzelne Speicherzelleneinrichtung umfasst ein weichmagnetisches Lese- und/oder Schreibschichtsystem, das über eine Zwischenschicht von einem hartmagnetischen, beim vorliegenden Typ an Speicherzelleneinrichtung als AAF-System ausgebildeten hartmagnetischen Referenzschichtsystem getrennt ist. Die Magnetisierung der Referenzschicht des Referenzschichtsystems ist stabil und ändert sich in einem anliegenden Feld nicht, während die Magnetisierung des weichmagnetischen Lese-und/oder Schreibschichtsystems über ein anliegendes Feld geschaltet werden kann. Die beiden magnetischen Schichtsysteme können zueinander parallel oder antiparallel magnetisiert sein. Die beiden vorgenannten Zustände stellen jeweils ein Bit von Informationen dar, d.h. den logischen Null ("0")-oder Eins ("1")-Zustand. Ändert sich die relative Orientierung der Magnetisierung der beiden Schichten von parallel nach antiparallel oder umgekehrt, so ändert sich der Magnetowiderstand über diese Schichtstruktur um einige Prozent. Diese Änderung des Widerstands kann für das Auslesen in der Speicherzelle abgelegter digitaler Information verwendet werden. Die Änderung des Zellwiderstands kann durch eine Spannungsänderung erkannt werden. Beispielsweise kann bei Spannungszunahme die Zelle mit einer logischen Null ("0") und bei einer Spannungsabnahme die Zelle mit einer logischen Eins ("1") belegt werden. Besonders große Widerstandsänderungen im Bereich von einigen Prozent wurden bei Änderung der Magnetisierungsausrichtung von parallel nach antiparallel und umgekehrt in Zellstrukturen vom GMR-Typ (Giant Magneto Resistance) oder dem TMR-Typ (Tunnel Magneto Resistance) beobachtet.

Ein wichtiger Vorteil derartiger magnetischer Speicherzellen liegt darin, dass auf diese Weise die Information persistent gespeichert ist, und ohne Aufrechterhaltung irgendeiner Grundversorgung auch bei ausgeschaltetem Gerät gespeichert und nach Einschalten des Geräts sofort wieder verfügbar ist, anders als bei bekannten herkömmlichen Halbleiterspeichern.

Ein zentraler Bestandteil hierbei ist das Referenzschichtsystem, das als AAF-System (AAF = Artifical-Anti-Ferromagnetic) ausgebildet ist. Ein derartiges AAF-System ist aufgrund seiner hohen magnetischen Steifigkeit und der relativ geringen Kopplung zum Lese- und/oder Schreibschichtsystem durch den sogenannten Orange-Peel-Effekt und/oder durch makroskopische magnetostatische Kopplungsfelder von Vorteil. Ein AAF-System besteht in der Regel aus einer ersten Magnetschicht oder einem Magnetschichtsystem, einer antiferromagnetischen Kopplungsschicht und einer zweiten magnetischen Schicht oder einem magnetischen Schichtsystem, das mit seiner Magnetisierung über die antiferromagnetische Kopplungsschicht entgegengesetzt zur Magnetisierung der unteren Magnetschicht gekoppelt wird. Ein solches AAF-System kann z. B. aus zwei magnetischen Co-Schichten und einer antiferromagnetischen Kopplungsschicht aus Cu gebildet werden.

Um die Steifigkeit des AAF-Systems, also seine Resistenz gegen externe äußere Felder zu verbessern, ist es üblich, an der dem Lese- und/oder Schreibschichtsystem abgewandten Magnetschicht des AAF-Systems eine antiferromagnetische Schicht anzuordnen. Über diese antiferromagnetische Schicht wird die direkt benachbarte Magnetschicht in ihrer Magnetisierung zusätzlich gepinnt, so dass das AAF-System insgesamt härter wird (exchange pinning oder exchange biasing).

Die magnetische Steifigkeit des AAF-Systems korrespondiert mit der Amplitude des angelegten externen Feldes, das zum Drehen der Magnetisierungen der beiden ferromagnetischen Schichten in die gleiche Richtung, also zur Parallelstellung erforderlich ist. Hierüber wird das magnetische Fenster für Lese- und Schreibanwendungen einer solchen Speicherzelleneinrichtung begrenzt.

Ziel ist es dabei stets, die magnetischen Schichten des AAF-Schichtsystems, das z.B. neben der eingangs genannten Materialkombination auch aus zwei ferromagnetischen CoFe-Schichten und einer dazwischen gebrachten Ru-Schicht bestehen kann, so homogen wie möglich zu magnetisieren, im Idealfall mit einer einzigen homogenen Magnetisierungsrichtung. Die Magnetisierung bei dem in Rede stehenden Speicherelement mit dem AAF-Schichtsystem und der zusätzlichen austauschkoppelnden bzw. pinnenden antiferromagnetischen Kopplungsschicht, z.B. aus IrMn, erfolgt derart, dass nach Erzeugen des Schichtstapels der Schichtstapel auf eine Temperatur größer als die blocking-Temperatur der antiferromagnetischen Schicht, also z.B. des IrMn erwärmt wird, wobei währenddessen ein starkes, die beiden magnetischen Schichten des AAF-Schichtsystems sättigendes Magnetfeld anliegt. Dies führt zu einer Ausrichtung der Magnetschichtmagnetisierungen, und aufgrund der Kopplungen auch der Magnetisierung der antiferromagnetischen Schicht. Anschließend wird die Temperatur wieder erniedrigt. Wird nun das externe Einstellmagnetfeld ebenfalls zurückgenommen, so beginnt die Magnetisierung der Magnetschicht, die nicht an die antiferromagnetische Schicht gekoppelt ist, sich aufgrund der AAF-Systemkopplung zu drehen.

Hierbei bilden sich jedoch eine Vielzahl von sogenannten 360°-Wänden in der Magnetisierung der Schicht aus. Diese 360°-Wände, die sich im Rahmen der Durchführung einer Domänen Beobachtung als gewundene, schlängelnde Linien zeigen, bringen eine Reihe von Nachteilen mit sich. So ist beispielsweise das über das Speicherelement abgreifbare Signal, beispielsweise ein TMR-Signal bei einem TMR-Speicherelement (TMR = Tunnel Magneto Resistive) reduziert. Auch ist das Ummagnetisierungsverhalten der über eine entkoppelnde Schicht, z.B. aus Al₂O₃, vom AAF-Schichtsystem getrennten Messschicht, z.B. aus Permalloy aufgrund der Streufelder, die über die 360°-Wände, in denen sich die Magnetisierung einmal um 360° dreht, ungünstiger.

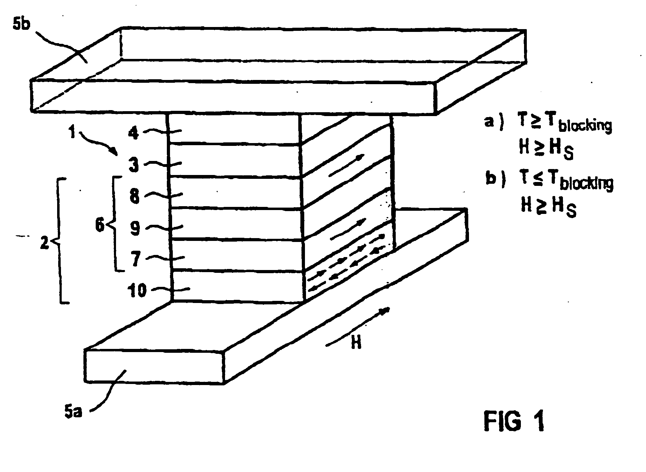

Im einzelnen wird im Dokument Journal of Applied Physics, Vol. 87, Nr. 9, 1. Mai 2000, Seiten 5055 bis 5057, ein Magnetisierungsverfahren beschrieben, bei dem Proben zunächst vorab aufmagnetisiert werden. Danach werden fünf verschiedene Feldstärken in derselben Geometrie mit umgepolter Feldrichtung angelegt, so dass eine Umpolung der Feldrichtung eintritt. Eine Rotation der Probe relativ zum Magnetfeld oder umgekehrt wird aber nicht vorgenommen. Weiterhin werden bei diesem bekannten Verfahren zwischen und nach den einzelnen Magnetisierungsmaßnahmen die Proben mit einem VSM-Magnetometer ("VSM = Vibrating Sample Magnetometer") gemessen, um damit sogenannte M(H)-Hysteresekurven, also die Abhängigkeit der Magnetisierung vom angelegten Feld, zu bestimmen. Dies kann ohne Weiteres in beliebigen Richtungen vorgenommen werden. Es sei angemerkt, dass die Charakterisierung von Magneten in allen Raumrichtungen seit langem bekannt ist. Genau in dieser Weise sind auch die Angaben im genannten Dokument hierzu zu verstehen: es handelt sich um Meßgeometrien, die dort beispielsweise als "Rotation" angegeben sind. Dies gilt auch für den Term "rotating" auf Seite 5057, linke Spalte, Absatz 2, Zeile 13 und für die entsprechenden Angaben in den Figuren 1 bis 4, in denen die Messung von Proben unter einem Winkel dargestellt ist, um so eine Charakterisierung dieser Proben vorzunehmen. Der sogenannte Spin-Flop, auf den sich das obengenannte Dokument bezieht, tritt bei austauschgekoppelten Systemen auf. In der Tat wird eine Scherung der Magnetisierung bei bestimmten, von außen angelegten Feldern beobachtet. Die verkippte Magnetisierung kann dann durch Absenken der Temperatur unterhalb die "blocking-Temperatur" durch einen angrenzenden Antiferromagneten eingefroren werden. Dies ist ohne Weiteres zutreffend. Diese eingefrorene Magnetisierung ist aber nicht notwendigerweise homogen.

Der Erfindung liegt das Problem zugrunde, ein Verfahren anzugeben, das eine homogene Magnetisierung unter weitgehendster Vermeidung der nachteiligen 360°-Wände ermöglicht.

Zur Lösung dieses Problems ist bei einem Verfahren der eingangs genannten Art erfindungsgemäß vorgesehen, dass bei festgelegter Richtung der Magnetisierung der antiferromagnetischen Schicht und Erwärmung dieser Schicht über ihre blocking-Temperatur die magnetischen Schichten des AAF-Schichtsystems in einem Magnetfeld gesättigt, die Temperatur unterhalb der blocking-Temperatur erniedrigt und anschließend die Lage der Richtung der Magnetisierung der antiferromagnetischen Schicht und der Richtung des sättigenden Magnetfelds relativ zueinander durch Rotation geändert wird, so dass sie unter einem Winkel α von 0° < α < 180° zueinander stehen, wonach das sättigende Magnetfeld abgeschaltet wird.

Die Magnetisierung der antiferromagnetischen Pin-Schicht, die aufgrund der sehr starken Austauschkopplung zur daran angrenzenden magnetischen Schicht des AAF-Schichtsystems deren Magnetisierung festhält, und die Richtung des Magnetfelds können unter einen Winkel < 180° und > 0° gebracht werden, und anschließend kann das Magnetfeld abgeschaltet werden. Aufgrund der bereits erfolgten Festlegung der Magnetisierungsrichtung der antiferromagnetischen Schicht wird nun die Magnetisierung der angrenzenden magnetischen Schicht des AAF-Systems automatisch in die gleiche Richtung drehen. Aufgrund der Kopplung der zweiten magnetischen Schicht des AAF-Systems über die dazwischen geordnete Kopplungsschicht dreht die Magnetisierung der zweiten magnetischen Schicht in die entgegengesetzte Richtung. Aufgrund der Stellung der Richtung der antiferromagnetischen Schichtmagnetisierung und des vorher noch anliegenden sättigenden Magnetfelds zueinander, muss jedoch nicht eine Drehung um 180° stattfinden, sondern lediglich um einen deutlich kleineren Winkel. Denn aufgrund der Winkelstellung und des vorher noch anliegenden sättigenden Magnetfelds steht die noch gesättigte Magnetisierung beider magnetischer AAF-Schichten nicht unter einem Winkel von 0 oder 180° zur Magnetisierung der antiferromagnetischen Schicht, sondern unter einem Zwischenwinkel. Lediglich um diesen Zwischenwinkel muss die Magnetisierung der zweiten magnetischen AAF-Schicht gedreht werden. Die Magnetisierung wird also bevorzugt ausschließlich in diese eine Richtung, die den kürzeren Drehweg aufweist und folglich ein energetisch günstigeres Drehen zulässt, drehen. Infolgedessen ist ein Zerfallen der Magnetisierung bzw. die Bildung der 360°-Wände ausgeschlossen, die sich primär dann bilden, wenn die Magnetisierung um 180° drehen muss, da in diesem Fall eine Drehung in zwei Richtungen, nämlich von 180° auf 0° bzw. von 180° auf 360° (letztlich nach "links" und "rechts") möglich ist, was zur Wandbildung führt. Durch die Einstellung der Magnetisierungsrichtungen wird also eine Vorzugs-Drehrichtung definiert, in welche die Schichtmagnetisierung dreht, was vorteilhaft zur Vermeidung der 360°-Wände führt.

Zweckmäßigerweise sollte ein Winkel α von 60° bis 120°, insbesondere von 90° eingestellt werden. Im Falle eines Winkels von 90° muss sowohl die über die antiferromagnetische Schicht gepinnte Magnetisierung der benachbarten AAF-Schicht um 90° drehen, die Magnetisierung der zweiten magnetischen Schicht muss ebenfalls um 90°, jedoch in die andere Richtung drehen. Der Weg ist insgesamt für beide Magnetisierungen relativ kurz, so dass sich eine homogene Magnetisierung einstellt.

Zum Einstellen des Winkels sind mehrere Möglichkeiten im Rahmen der Magnetisierung denkbar. Zum einen kann das Speicherelement bezüglich des feststehenden Magnetfelds gedreht werden, alternativ dazu besteht die Möglichkeit, das Magnetfeld bezüglich des feststehenden Speicherelements zu bewegen. Schließlich können auch beide bezüglich einander bewegt werden.

Mit dem erfindungsgemäßen Verfahren ist es möglich, bereits bei der erstmaligen Magnetisierung eines Speicherelements die Bildung von 360°-Wänden zu vermeiden. Zu diesem Zweck wird zur Einstellung der Magnetisierung der antiferromagnetischen Schicht die Temperatur über die blocking-Temperatur der Schicht erhöht, wobei das sättigende Magnetfeld während der Temperaturerhöhung anliegt, wonach die Temperatur erniedrigt wird und die Einstellung der Magnetisierung des Schichtsystems erfolgt. Hierbei wird also gleichzeitig die Sättigung der magnetischen Schichten des AAF-Systems und die Einstellung der Magnetisierung der antiferromagnetischen Schicht vorgenommen, die, da die Temperatur über der blocking-Temperatur liegt, sich der Magnetisierungsrichtung der benachbarten magnetischen Schicht des AAF-Systems anpasst. Anschließend wird die Temperatur erniedrigt, so dass die Magnetisierung der antiferromagnetischen Schicht nach Unterschreiten der blocking-Temperatur quasi eingefroren wird. Anschließend erfolgt die Drehung des Speicherelements und/oder des Magnetfelds zur Einstellung des Winkels α bei nach wie vor anliegendem Magnetfeld, wonach diese abgeschaltet wird und die Magnetisierungen der beiden magnetischen Schichten des AAF-Systems in die beiden unterschiedlichen Richtungen drehen.

Gleichermaßen ist es mit dem erfindungsgemäßen Verfahren aber auch möglich, ein bereits magnetisiertes Speicherelement, das 360°-Wände aufweist, also inhomogen magnetisiert ist, nachträglich zu homogenisieren. Zu diesem Zweck wird die Magnetisierung des AAF-Schichtsystems in einem ausreichend hohen Magnetfeld gesättigt, ohne dass vorher die Temperatur erhöht wird. Nach Sättigung wird das System bezüglich des Magnetfelds gedreht, z.B. um 90° zur ursprünglichen Sättigungsrichtung der antiferromagnetischen Schicht, wobei diese zweckmäßigerweise vorher parallel zum externen Sättigungsmagnetfeld ausgerichtet wurde bzw. das Speicherelement entsprechend positioniert wurde. Nach dem Drehen wird das externe Magnetfeld zurückgefahren, so dass die Schichtmagnetisierungen, die trotz der Drehung aufgrund der Sättigung in Richtung des externen Magnetfelds lagen, um die entsprechenden Winkelabschnitte zurückzudrehen.

Eine magneto-resistive Speicherzelleneinrichtung kann verfahrensgemäß magnetisiert werden. Eine magneto-resistive Speichereinrichtung umfasst mehrere Speicherzelleneinrichtungen.

Eine nichterfindungsgemässe Vorrichtung zur Durchführung des Verfahrens umfasst eine Aufnahme für ein mindestens ein Speicherelement aufweisendes Substrat sowie eine Magnetfelderzeugungseinrichtung. Die Vorrichtung zeichnet sich dadurch aus, dass die Aufnahme und die Magnetfelderzeugungseinrichtung bezüglich zueinander drehbar sind. Nach einer ersten Ausgestaltung kann die Aufnahme ein Drehteller und die Magnetfeldererzeugungseinrichtung feststehend sein, d.h. hier wird das Substrat, an dem naturgemäß eine Vielzahl von Speicherelementen ausgebildet sind, bezüglich des feststehenden Magnetfelds gedreht. Alternativ kann die Aufnahme feststehend und die Magnetfelderzeugungseinrichtung drehbar sein.

Besonders vorteilhaft ist es, wenn die Aufnahme, gegebenenfalls der Drehteller beheizbar ist, um das Substrat möglichst schnell auf eine Temperatur oberhalb der blocking-Temperatur zu erwärmen, wenn dies erforderlich ist.

Weitere Vorteile, Merkmale und Einzelheiten der Erfindung ergeben sich aus den im folgenden beschriebenen Ausführungsbeispiel sowie anhand der Zeichnungen. Dabei zeigen:
- Fig. 1: eine Prinzipskizze einer Speicherzelleneinrichtung während des Aufmagnetisierens mit einer oberhalb der blocking-Temperatur liegenden Temperatur bei anliegendem sättigendem Magnetfeld,
- Fig. 2: die Speicherzelleneinrichtung aus Fig. 1 nach einer Drehung bei feststehendem sättigendem Magnetfeld und vorangegangener Temperaturerniedrigung,
- Fig. 3: die Speicherzelleneinrichtung aus Fig. 2 nach Abschalten des Magnetfelds,
- Fig. 4: eine Prinzipskizze einer nicht erfindungsgemässe Vorrichtung, die geeignet ist, das beanspruchts Verfahren auszuführen.
- Fig. 5: eine Prinzipskizze einer Vorrichtung, die geeignet ist, das beanspruchte Verfahren auszuführen.

Fig. 1 zeigt eine Speicherzelleneinrichtung 1. Diese besteht aus einem sogenannten Referenzschichtsystem 2, das über eine Entkopplungsschicht 3, z.B. Al₂O₃ von einem weichmagnetischen Messschichtsystem 4 entkoppelt ist. Gezeigt sind ferner die Wort- und Bitleitungen 5a, 5b, die oberhalb und unterhalb rechtwinklig zueinander verlaufen. Das Referenzschichtsystem 2 besteht aus einem AAF-Schichtsystem 6, bestehend aus einer unteren ferromagnetischen Schicht 7, einer oberen ferromagnetischen Schicht 8 und einer zwischen diesen angeordneten, antiparallel koppelnden Kopplungsschicht 9. Die ferromagnetischen Schichten können z.B. aus Co oder CoFe sein, die antiparallel koppelnde Kopplungsschicht kann aus Cu oder aus Ru sein. Der Aufbau eines solchen AAF-Schichtsystems ist hinlänglich bekannt.

Das Referenzschichtsystem 2 umfasst ferner eine unterhalb der unteren ferromagnetischen Schicht 7 vorgesehene antiferromagnetische Schicht 10, z.B. aus Ni, FeMn, IrMn, NiMn, PtMn, CrPtMn, RhMn oder PdMn. Die antiferromagnetische Schicht 10 koppelt die Magnetisierung der darüber befindlichen unteren ferromagnetischen Schicht 7, d.h. diese richtet sich parallel zu den magnetischen Momenten der antiferromagnetischen Schicht im Grenzflächenbereich aus. Hierdurch wird durch exchange biasing die Magnetisierung der ferromagnetischen Schicht 7 gepinnt. Auch diese Funktion bzw. dieser Aufbau ist hinlänglich bekannt.

Zum Einstellen der Magnetisierung der magnetischen Schichten 7 und 8 und auch der Magnetisierung der antiferromagnetischen Schicht 10 wird die Speicherzelleneinrichtung, die hier nur in Form einer Prinzipskizze als Ausschnitt gezeigt ist, und die normalerweise an einem großflächigen Wafer mit einer Vielzahl weiterer Speicherelemente ausgebildet ist, auf eine Temperatur T oberhalb der blocking-Temperatur T_{blocking} der antiferromagnetischen Schicht 10 erwärmt. Bei einer Temperatur oberhalb der blocking-Temperatur verliert die antiferromagnetische Schicht ihre antiferromagnetischen Eigenschaften. Die magnetischen Momente der Schicht können durch ein externes Magnetfeld ausgerichtet werden. Ein solches externes Magnetfeld H wird angelegt, wobei dieses größer ist als das Sättigungsmagnetfeld Hₛ das benötigt wird, um die Magnetisierungen der magnetischen Schichten 7, 8 zu sättigen. Ersichtlich richten sich die Magnetisierungen der Schichten 7, 8, die durch die langen Pfeile dargestellt sind, parallel zum externen Feld aus; auch die magnetischen Momente der antiferromagnetischen Schicht 10 richten sich entsprechend aus, wobei die grenzflächennahen Momente, die im Grenzflächenbereich zur magnetischen Schicht 7 liegen, parallel dazu koppeln.

Anschließend wird die Temperatur erniedrigt, so dass sie unterhalb der blocking-Temperatur T_{blocking} ist. Bei Unterschreiten der blocking-Temperatur geht die antiferromagnetische Schicht 10 wieder in den antiferromagnetischen Zustand über, die Magnetisierung wird "eingefroren". Das externe Magnetfeld liegt jedoch nach wie vor sättigend an.

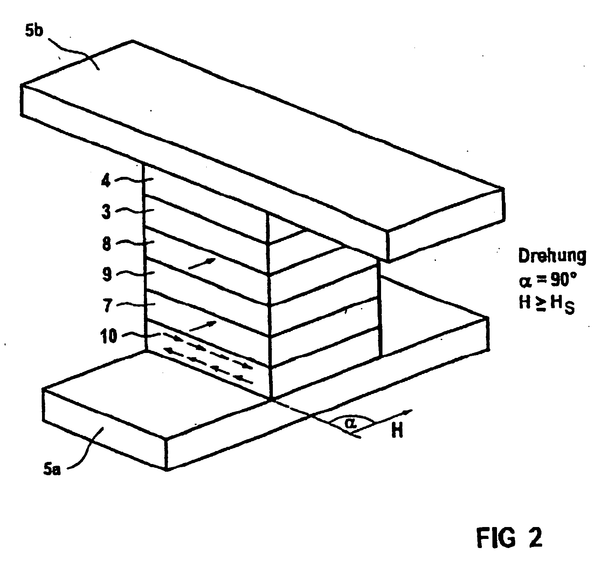

Wie Fig. 2 zeigt erfolgt anschließend eine Drehung um einen Winkel α, wobei α in diesem Fall 90° beträgt. Ersichtlich bleibt die Magnetisierung der antiferromagnetischen Schicht 10 in der vormals eingestellten Richtung, d.h. sie ändert sich trotz des nach wie vor anliegenden externen sättigenden Magnetfelds H nicht. Der Winkel α ist der Winkel, den die Magnetisierungsrichtung der Schicht 10 zum externen Magnetfeld H einnimmt, wie dies in Fig. 2 eingezeichnet ist.

Anders als die feststehende Magnetisierung der antiferromagnetischen Schicht 10 drehen sich bei einer Drehung der Speicherzelleneinrichtung bezüglich des feststehenden externen Magnetfelds die Magnetisierungen der magnetischen Schichten 7 und 8 während der Drehung, d.h. sie verbleiben nach wie vor parallel zum externen Magnetfeld H, wie Fig. 2 deutlich zeigt. Sie stehen also unter einem Winkel zur Richtung der Magnetisierung der antiferromagnetischen Schicht 10, wobei der Winkel ebenfalls α = 90° beträgt.

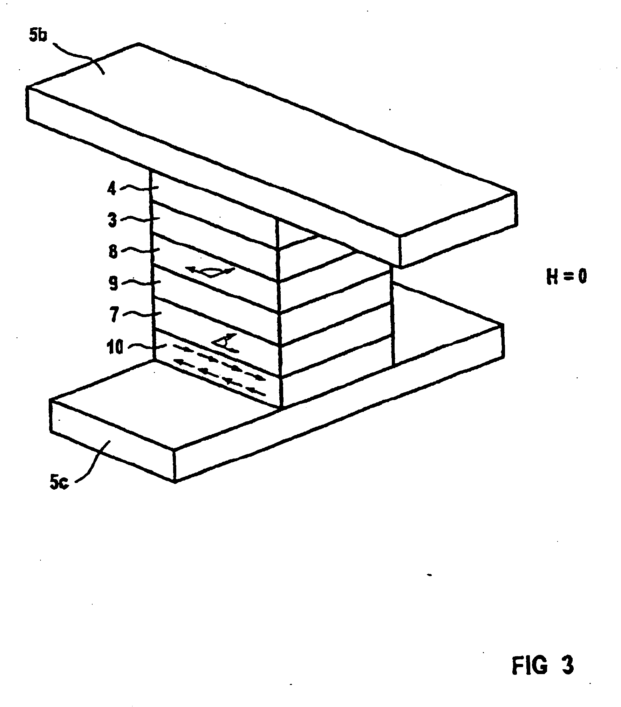

Nachfolgend wird, siehe Fig. 3, das externe Magnetfeld abgeschaltet. Dies führt dazu, dass in den beiden magnetischen Schichten 7 und 8 unterschiedlich gerichtete Drehprozesse stattfinden. Während sich die Magnetisierung der unteren magnetischen Schicht 7, die benachbart zur antiferromagnetischen Schicht 10 liegt, im gezeigten Beispiel nach rechts und damit parallel zu den grenzflächennahen Momenten der antiferromagnetischen Schicht 10 einstellt, was durch die starke Austauschkopplung zwischen beiden Schichten bedingt ist, dreht die Magnetisierung der magnetischen Schicht 8 aufgrund der Kopplungseigenschaften der Kopplungsschicht 9 in die entgegengesetzte Richtung. In Fig. 3 sind jeweils die Ausgangsstellungen der Magnetisierungen gestrichelt gezeigt, wie sie aus Fig. 2 bekannt sind; die durchgezogenen Pfeile geben die jeweilige Endstellung nach erfolgter Drehung wieder. Ersichtlich drehen beide Magnetisierungen lediglich um einen relativ kleinen Winkel, nämlich um 90°, bedingt durch die vorher eingenommene Stellung der Speicherzelleneinrichtung bezüglich des externen Magnetfelds, wie dies anhand von Fig. 2 beschrieben wurde. Für die jeweilige Magnetisierung der Schichten 7, 8 existiert ein ausgezeichneter kürzester Drehweg, um in die jeweils kopplungsbedingt definierte Stellung zu drehen. Ein Zerfall der Magnetisierung in unterschiedliche Magnetisierungsbereiche bzw. die Bildung von unerwünschten 360°-Wänden wird aufgrund dieser Vorzugsdrehrichtung ausgeschlossen.

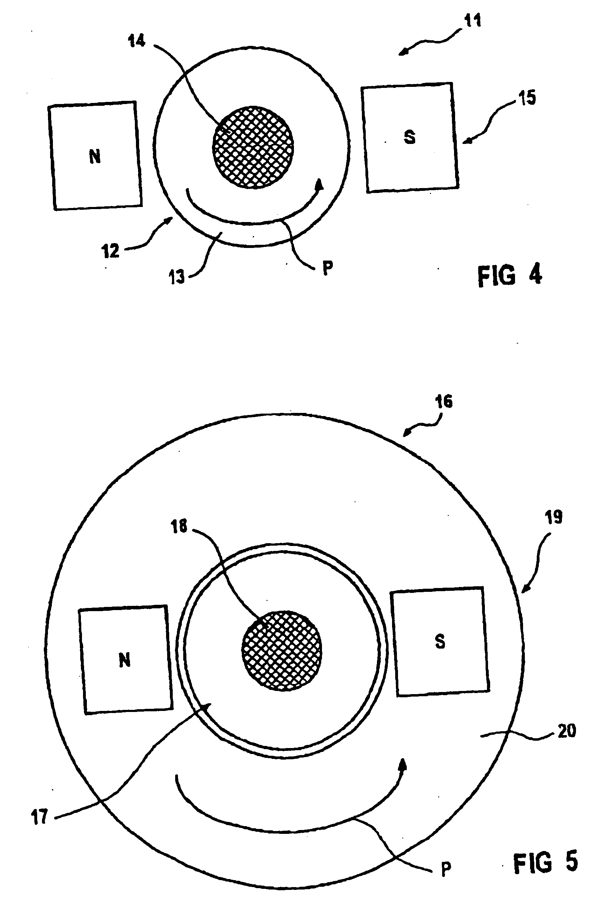

Fig. 4 zeigt eine nichtfferfindungs gemässe Vorrichtung 11, die zur Durchführung des bezüglich der Figuren 1 - 3 beschriebenen Verfahrens geeignet ist sie umfasst eine Aufnahme 12 in Form eines Drehtellers 13, der wie der Pfeil P zeigt gedreht werden kann. Auf ihm wird ein Substrat 14, an dem eine Vielzahl von Speicherzelleneinrichtungen (die eine Speichereinrichtung bilden) mit dem eingangs beschriebenen Schichtsystem ausgebildet sind, angeordnet. Der Drehteller 13 selbst ist zweckmäßigerweise beheizbar. Ihm zugeordnet ist eine Magnetfelderzeugungseinrichtung 15, wie diese durch die beiden magnetischen Pole N und S angedeutet ist. Zur Durchführung des Verfahrens wird das Substrat 14 auf dem Drehteller 13 positioniert, anschließend erfolgt die starke Erwärmung und das Anlegen des externen sättigenden Magnetfelds, wonach die Abkühlung und anschließende Drehung und letztendlich die Abschaltung des externen Magnetfelds vorgenommen wird, wie dies bezüglich der Figuren 1 - 3 ausführlich beschrieben wurde.

Fig. 5 zeigt eine weitere nicht erfindungs gemässe Vorrichtung 16. Bei dieser ist die Aufnahme 17 als beheizbarer Tisch ausgebildet, der jedoch nicht drehbar ist. Auch auf der Aufnahme 17 ist ein Substrat 18 anzuordnen. Demgegenüber ist die Magnetfelderzeugungseinrichtung 19, die auch hier wieder durch die beiden Pole N und S angedeutet ist, auf einer geeigneten Dreheinrichtung 20, z.B. in Form eines Drehtellers drehbar gelagert, wie dies der Pfeil P ebenfalls zeigt. Bei dieser Vorrichtung ist ein etwas abgewandeltes Verfahren zur Erzeugung einer homogenen Magnetisierung möglich. Anstelle der bezüglich Fig. 2 beschriebenen Drehung der Speicherzelleneinrichtung bezüglich des feststehenden Magnetfelds bleibt hier die Speicherzelleneinrichtung ruhend, während das Magnetfeld zur Einstellung des Winkels α gedreht wird.

Insgesamt schlägt die Erfindung ein einfach praktikables, keine zusätzlichen zeit- oder kostenaufwendigen Verfahrensschritte erforderndes Verfahren vor, das die homogene Magnetisierung der relevanten Schichten einer Speicherzelleneinrichtung oder Speichersystems ermöglicht.

## Patentansprüche

1. Verfahren zur homogenen Magnetisierung eines austauschgekoppelten Schichtsystems einer digitalen magnetischen Speicherzelleneinrichtung umfassend ein magnetische Schichten (7, 8, 9) aufweisendes AAF-Schichtsystem (6) und eine eine Schicht (7) des AAF-Schichtsystems (6) austauschkoppelnde antiferromagnetische Schicht (10),
**dadurch gekennzeichnet, dass** bei festgelegter Richtung der Magnetisierung der antiferromagnetischen Schicht (10) und Erwärmung dieser Schicht (10) über ihre blocking-Temperatur die magnetischen Schichten (7, 8, 9) des AAF-Schichtsystems (6) in einem Magnetfeld gesättigt, die Temperatur unterhalb der blocking-Temperatur erniedrigt und anschließend die Lage der Richtung der Magnetisierung der antiferromagnetischen Schicht (10) und der Richtung des sättigenden Magnetfelds relativ zueinander durch Rotation geändert wird, so dass sie unter einem Winkel α von 0° < α < 180° zueinander stehen, wonach das sättigende Magnetfeld abgeschaltet wird.

2. Verfahren nach Anspruch 1,
**dadurch gekennzeichnet, dass** ein Winkel α zwischen 60° und 120°, insbesondere von 90°, eingestellt wird.

3. Verfahren nach Anspruch 1 oder 2,
**dadurch gekennzeichnet, dass** zum Einstellen des Winkels die Speicherzelleneinrichtung bezüglich des feststehenden Magnetfelds gedreht wird.

4. Verfahren nach Anspruch 1 oder 2,
**dadurch gekennzeichnet, dass** zum Einstellen des Winkels das Magnetfeld bezüglich der feststehenden Speicherzelleneinrichtung bewegt wird.

5. Verfahren nach Anspruch 1 oder 2,
**dadurch gekennzeichnet, dass** zum Einstellen des Winkels das Magnetfeld und die Speicherzelleneinrichtung bewegt werden.

## Claims

1. Method for homogeneously magnetizing an exchange-coupled layer system of a digital magnetic memory cell device comprising an AAF layer system (6) having magnetic layers (7, 8, 9) and an antiferromagnetic layer (10) that exchange-couples a layer (7) of the AAF layer system (6), **characterized in that**, given a defined direction of magnetization of the antiferromagnetic layer (10) and heating of this layer (10) above its blocking temperature, the magnetic layers (7, 8, 9) of the AAF layer system (6) are saturated in a magnetic field, the temperature is decreased to below the blocking temperature and, afterward, the position of the direction of the magnetization of the antiferromagnetic layer (10) and the direction of the saturating magnetic field relative to one another is changed by rotation, so that they are at an angle α of 0° < α < 180° relative to one another, after which the saturating magnetic field is switched off.

2. Method according to Claim 1, **characterized in that** an angle α of between 60° and 120°, in particular of 90°, is set.

3. Method according to Claim 1 or 2, **characterized in that**, for the purpose of setting the angle, the memory cell device is rotated with respect to the stationary magnetic field.

4. Method according to Claim 1 or 2, **characterized in that**, for the purpose of setting the angle, the magnetic field is moved with respect to the stationary memory cell device.

5. Method according to Claim 1 or 2, **characterized in that**, for the purpose of setting the angle, the magnetic field and the memory cell device are moved.

## Revendications

1. Procédé d'aimantation homogène d'un système de couches couplé par échange d'un dispositif de cellules de mémoire numérique magnétique comprenant un système (6) de couches AAF ayant des couches (7, 8, 9) magnétiques et une couche (10) anti-ferromagnétique couplant par échange une couche (7) du système (6) de couche AAF,
**caractérisé en ce que** pour une direction fixée de l'aimantation de la couche (10) anti-ferromagnétique et par échauffement de cette couche (10) au-delà de sa température de blocage, on sature dans un champ magnétique les couches (7, 8 , 9) magnétiques du système (6) de couche AAF, on abaisse la température en-dessous de la température de blocage et ensuite on modifie la position de la direction de l'aimantation de la couche (10) anti-ferromagnétique et de la direction du champ magnétique de saturation l'une par rapport à l'autre par rotation de manière à ce qu'elles fassent entre elles un angle α de 0° < α < 180°, puis on interrompt le champ magnétique de saturation.

2. Procédé suivant la revendication 1, **caractérisé en ce qu'**on règle un angle α compris entre 60° et 120 °, notamment de 90°.

3. Procédé suivant la revendication 1 ou 2,
**caractérisé en ce que** pour régler l'angle on fait tourner le dispositif de cellule de mémoire par rapport au champ magnétique fixe.

4. Procédé suivant la revendication 1 ou 2,
**caractérisé en ce que**, pour régler l'angle, on déplace le champ magnétique par rapport au dispositif de cellules de mémoire fixe.

5. Procédé suivant la revendication 1 ou 2,
**caractérisé en ce que**, pour régler l'angle, on déplace le champ magnétique et le dispositif de cellules de mémoire.
